Europäisches Patentamt

European Patent Office

Office européen des brevets

(11) Veröffentlichungsnummer: **0 143 244**
**B1**

(12) **EUROPÄISCHE PATENTSCHRIFT**

(45) Veröffentlichungstag der Patentschrift:
**16.08.89**

(51) Int. Cl.⁴: **H 01 L 23/48, H 01 L 23/14**

(21) Anmeldenummer: **84111234.5**

(22) Anmeldetag: **20.09.84**

(54) **Kontaktelektrode für Leistungshalbleiterbauelemente.**

(30) Priorität: **01.10.83 DE 3335836**

(43) Veröffentlichungstag der Anmeldung:
**05.06.85 Patentblatt 85/23**

(45) Bekanntmachung des Hinweises auf die Patenterteilung:
**16.08.89 Patentblatt 89/33**

(84) Benannte Vertragsstaaten:
**CH DE FR GB IT LI NL SE**

(56) Entgegenhaltungen:
**EP-A- 0 051 459**
**EP-A- 0 064 231**

**ELECTRONIC DESIGN, Band 30, Nr. 9, 29. April 1982, Seiten 147-152, R.L. WILLIAMS et al.: "Fast transistors push up power limits"**

(73) Patentinhaber: **Asea Brown Boveri Aktiengesellschaft,**
**Kallstadter Strasse 1, D-6800 Mannheim-Käfertal (DE)**

(72) Erfinder: **Neidig, Arno, Dr., Dipl.-Phys., Brühler Weg 42,**
**D-6831 Plankstadt (DE)**
Erfinder: **Grobrecht, Jens, Dr., Dipl.-Ing.,**
**Birchhofstrasse 6, CH-5412 Gebenstorf (CH)**

(74) Vertreter: **Rupprecht, Klaus, Dipl.-Ing. et al, c/o Asea**
**Brown Boveri Aktiengesellschaft Zentralbereich**
**Patente Postfach 100351, D-6800 Mannheim 1 (DE)**

## Beschreibung

Die Erfindung betrifft eine Kontaktelektrode zur Kontaktierung von Leistungshalbleiterbauelementen mit verteilter Elektrodenstruktur nach dem Oberbegriff des Anspruchs 1 bzw. des nebengeordneten Anspruchs 8. Leistungshalbleiterbauelemente mit verteilter Elektrodenstruktur können z.B. Leistungstransistoren, GTO-Thyristoren und Frequenzthyristoren sein.

Bei Halbleiterbauelementen kleiner Leistung ist es üblich, die elektrischen Verbindungen zwischen der Emitter- und Basis-Metallisierung von Transistorchip bzw. der Kathoden- und Gate-Metallisierung von Thyristorchip und den äußeren Anschlüssen des Bauelements über dünne Aluminiumdrähte mit etwa 0,2 bis 0,5 mm Durchmesser herzustellen. Dabei besteht die Metallisierung der Kontaktflächen üblicherweise aus einer etwa 4 bis 6 µm dicken Aluminiumschicht und die Verbindung der Aluminiumdrähte mit den metallisierten Kontaktflächen erfolgt meistens durch das bekannte Ultraschall-Bonden.

Für Bauelemente größerer Leistung ist allerdings die geringe Stromtragfähigkeit der dünnen Aluminiumdrähte nachteilig und zur Kontaktierung großflächiger Chip sind Mehrfach-Bondungen nötig. Eine Schwachstelle ist außerdem die Verbindung zwischen Aluminium-Metallisierung des Chips und dem Aluminiumdraht, da nach häufigen Lastwechseln mit einer Erhöhung des Übergangwiderstands zu rechnen ist. Weiterhin ist nachteilig, daß keine großflächige Kontaktierung erfolgt, so daß ein relativ hoher Verteilungsstrom in der dünnen Aluminiumschicht der Kontaktfläche fließt, die nur eine geringe Wärmekapazität aufweist.

Bei einem anderen bekannten Verfahren werden mit Weichlot beschichtete Spangen auf die Kontaktfläche der Chip gedruckt. Die Anordnung wird bis zur Schmelztemperatur des Lotes erwärmt, so daß eine feste Lötverbindung entsteht. Auch dabei erfolgt jedoch eine Stromführung in der dünnen Aluminiumschicht.

Diese Nachteile sind bei einem weiteren bekannten Verfahren beseitigt, bei dem die Kontaktflächen auf ihrer gesamten Fläche mit einem Metallgitter kontaktiert werden. Die Herstellung und Montage dieses feingliedrigen Metallteils ist allerdings sehr aufwendig. Bei nach diesem Verfahren hergestellten Bauelementen wird Kupfer für das Metallteil verwendet. Dabei ergeben sich jedoch bei Temperaturzyklen Probleme durch die thermische Fehlanpassung. Bei Verwendung von Molybdän oder Wolfram ist zwar die thermische Anpassung gut, die Verarbeitung zu einer feinen Struktur ist aber aufwendig.

Weiterhin ist aus Electronic Design, 29. April 1982, Seite 147 und 148 eine Möglichkeit zur Verbindung eines Molybdängitters mit einer verzweigten Kontaktfläche durch Druckkontakt bekannt. Dabei wird mittels Stahlfedern Druck auf eine Molybdänträgerplatte und ein darunterliegendes Molybdängitter ausgeübt, wodurch ein Kontakt zu den Kontaktflächen des Chip hergestellt wird. Der bruchempfindliche Siliziumchip ist auf eine Molybdänscheibe aufgelegt um die mechanische Festigkeit zu verbessern.

Nachteilig ist bei der Kontaktierung durch Druckkontakt, daß die Herstellung des Molybdängitters aufwendig ist und eine zusätzliche Molybdänträgerplatte über dem Gitter benötigt wird. Durch den komplizierten Aufbau ergeben sich Justier- und Montageprobleme. Wenn das Halbleiterbauelement in ein Kunststoffgehäuse eingebaut wird, das gegen Feuchtigkeit und schädliche Gase aus der Luft nicht hermetisch dicht abschließt, ist mit einem Anstieg des Durchlaßspannungsabfalls zu rechnen, da an den Grenzflächen zwischen den druckkontaktierten Scheiben Gase und Feuchte absorbiert werden. Außerdem ist nachteilig, daß eine Legierung von Siliziumchip und Molybdänscheibe zur mechanischen Verstärkung erforderlich ist. Das Legieren ist jedoch für eine rationelle Massenproduktion weniger geeignet, da z.B. Reinigungs- und Ätzprozesse sowie Prozeßschritte der Passivierung am einzelnen Chip durchgeführt werden müssen. Die Verbindung von Glaspassivierung und Legieren ist bisher nicht möglich. Eine Kunststoffpassivierung allein, wie bei legierten Silizium-Bauelementen üblich, reicht bei kunststoffgekapselten Bauelementen nicht aus, um die notwendige Stabilität der Blockier- und Sperreigenschaften des Chips zu erreichen.

Schließlich ist aus der EP-A-0 051 459 eine Kontaktelektrode zur Kontaktierung von Leistungshalbleiterbauelementen, die eine verteilte Elektrodenstruktur aufweisen, bekannt. Diese Kontaktelektrode besteht aus einer elektrisch isolierenden Kunststoffolie, die auf einer Seite strukturierte metallische Kontaktflächen aufweist, deren Form an die Struktur der Elektroden eines Leistungshalbleiterbauelements angepaßt ist, mit dem die Kontaktelektrode verlötet werden soll.

Die vorgeschlagenen Kontaktelektroden haben eine hohe mechanische Festigkeit und sind bei der Montage auf ein Leistungshalbleiterbauelement gut handhabbar.

Als erste Variante wird eine Kontaktelektrode mit einem Plättchen aus Keramik als Trägermaterial vorgeschlagen. Durch Verwendung der elektrisch isolierenden Keramik können auf einer Kontaktelektrode auf vorteilhafte Weise mehrere voneinander isolierte Kontaktflächen, z.B. für Emitter und Basis eines Transistors, angeordnet werden. Die Kontaktelektrode zeichnet sich außerdem durch hohe mechanische Festigkeit aus.

Zum Aufbringen der für die Herstellung der Kontaktflächen erforderlichen Metallisierung eignet sich besonders ein Verfahren zum direkten Verbinden von Metall mit Keramik, da damit eine hohe Haftfestigkeit der Metallisierung auf dem Kontaktplättchen erreicht wird. Für die Metallisierung wird vorzugsweise das in solchen sogenannten «Direct-Bonding»-Verfahren bewährte Kupfer verwendet. Um bei Erwärmung ein Durchbiegen des Kontaktplättchens auszuschließen, kann nach einer vorteilhaften Ausgestaltung die Rückseite des Keramikplättchens ebenfalls metallisiert werden. Schließlich ist es vorteilhaft, als Keramik Mullit zu verwenden, da der Ausdehnungskoeffizient von Mullit gut an den Ausdehnungskoeffizienten von Silizium angepaßt ist, aus dem das Leistungshalbleiterbauelement besteht, mit dem die Kontaktelektrode später verlötet wird.

Als zweite Variante wird eine Kontaktelektrode mit einem Plättchen aus Silizium vorgeschlagen. Die Verwendung von Silizium zur Herstellung der Kontaktelektrode bringt eine Reihe von Vorteilen mit sich. Da auch das aktive Halbleiterelement aus Silizium besteht, gibt es keine Probleme durch unterschiedliche Ausdehnung. Die Struktur für die Kontaktflächen kann in eine noch unzerteilte Scheibe geätzt werden. Das Ätzen und das Zerteilen der Scheibe ist leicht und billig nach bekannten Verfahren und mit bei Halbleiterherstellern vorhandenen Einrichtungen möglich. Es können feine Strukturen mit engen Toleranzen formstabil hergestellt werden. Mit beiden Varianten der Kontaktelektrode können vorteilhaft unabhängig voneinander metallisierte Flächen (Inseln) auf einem Halbleiterchip elektrisch miteinander verbunden werden.

Weitere Vorteile sind der nachstehenden Beschreibung von Ausführungsbeispielen zu entnehmen. Die Erfindung wird anhand der Zeichnung und des Herstellungsprozesses beschrieben.

Es zeigen:

Fig. 1 Aufbau einer Silizium-Kontaktelektrode,

Fig. 2 Draufsicht auf eine Silizium-Kontaktelektrode,

Fig. 3 Leistungshalbleiterbauelement mit fünf Emitterelektroden,

Fig. 4 Sandwich aus Leistungshalbleiterbauelement und Kontaktelektrode,

Fig. 5 bis 7 Keramik-Kontaktelektrode nach verschiedenen Herstellungsschritten,

Fig. 8 fertige mit Lot benetzte Keramik-Kontaktelektrode,

Fig. 9 Draufsicht auf die strukturierte Kontaktfläche einer Keramik-Kontaktelektrode,

Fig. 10 Schnittbild einer auf ein Halbleiterchip aufgelöteten Keramik-Kontaktelektrode.

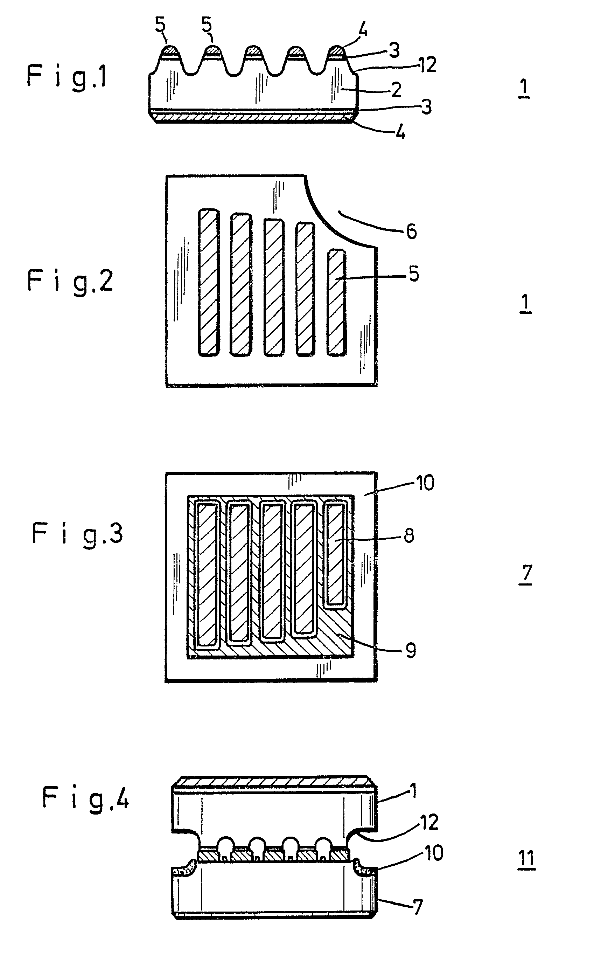

Bei der Herstellung der Kontaktelektrode nach den Fig. 1 bis 4 geht man von einer Siliziumscheibe aus. Bevorzugt wird monokristallines Silizium wegen seiner relativ hohen Bruchfestigkeit und guten Ätzbarkeit. Um die nötige elektrische Leitfähigkeit einzustellen, soll der spezifische Widerstand bei etwa 1 bis 5 $m\Omega cm$ liegen. Es kommt bei dieser Anwendung nicht auf extrem hohe Reinheit und Fehlerfreiheit des Siliziums an, so daß die Kosten entsprechend gering sind. Die Siliziumscheibe hat zweckmäßig einen Durchmesser von 2 bis 5″ und eine Dicke von 0,3 bis 1 mm. Zur Herstellung von Kontaktelektroden mit Leiterbahnbreiten und Abständen über etwa 50 μm sind nachstehende Herstellungsschritte geeignet:

1. Beidseitiges Sanden und Reinigen der von einem Siliziumstab abgesägten Siliziumscheibe zur Beseitigung von Schmutz nach dem Sägen.

2. Beidseitige Aufbringung einer lötfähigen Metallisierung zweckmäßigerweise durch stromloses Vernickeln und Vergolden.

3. Beidseitige Maskierung mittels Siebdruckverfahren durch Verwendung eines säurefesten Siebdrucklacks. Auf einer Seite der Siliziumscheibe ist der Lack entsprechend dem zu kontaktierenden Muster auf dem Leistungshalbleiterbauelement verteilt. Auf dieser Seite werden gleichzeitig auch entsprechende Muster als Justierhilfen aufgedruckt.

4. Ätzen der Metallisierung und des Siliziums an den nicht maskierten Stellen mit bekannten Säuren bzw. Säuregemischen. Das Silizium wird hierbei 100 bis einige Hundert Mikrometer angeätzt. Die Scheibe wird jedoch nicht durchgeätzt. Geätzt werden dabei auch die späteren Trennstellen für die Zerteilung der Scheibe in mehrere Plättchen für Kontaktelektroden.

5. Danach folgen Spül- und Reinigungsprozesse um zunächst Säurereste und dann den Siebdrucklack zu entfernen.

6. Heraustrennen von Öffnungen für Gate- bzw. Basisanschlüsse durch Laser-Schneiden.

7. Zerteilen der Scheibe in einzelne Plättchen in der Form der herzustellenden Kontaktelektroden mittels Kristallsäge. Je nach Größe des zu kontaktierenden Bauelementes können damit bis zu einigen Hundert Kontaktelektroden aus einer Scheibe hergestellt werden.

8. Es folgt eine Benetzung der Metallisierung auf den Plättchen mit Weichlot. Dies kann in einem Tauchlötbad erfolgen. Alternativ kann die Benetzung auch nur auf der strukturierten Seite zwischen den Schritten 6 und 7, wie in der Dickfilm-Hybrid-Technik üblich, z.B. im Schwall-Lötbad oder Dampf-Lötbad an den noch unzerteilten Platten erfolgen. Das Lot bleibt dabei nur an den metallisierten Flächen haften.

In Fig. 1 ist eine Kontaktelektrode 1 dargestellt, die nach dem vorstehend beschriebenen Verfahren hergestellt wurde. Das auf einer Seite durch Ätzen strukturierte Siliziumplättchen 2 trägt auf der Ober- und Unterseite eine Metallisierung 3, die mit Lot 4 benetzt ist. Die durch Ätzen entstandenen Strukturen stellen Kontaktflächen 5 dar. Ebenfalls durch Ätzung ist eine Randvertiefung 12 zur Verbesserung der elektrischen Überschlagsfestigkeit hergestellt.

Fig. 2 zeigt eine Sicht auf Kontaktflächen 5 der Kontaktelektrode 1. In dieser Draufsicht ist auch ein Ausschnitt oder eine Öffnung 6 für einen Gate- oder Basisanschluß zu erkennen.

Fig. 3 zeigt ein Leistungshalbleiterbauelement 7 (z.B. einen Transistor), das mit einer Kontaktelektrode 1 kontaktiert werden soll. Das Halbleiterbauelement 7 hat fünf Emitterelektroden 8, denen die Form der Kontaktflächen 5 der Kontaktelektrode 1 angepaßt ist. Dargestellt sind weiterhin eine Basiselektrode 9 und Passivierungsglas 10.

Fig. 4 zeigt einen Sandwich 11, der aus einem Leistungshalbleiterbauelement 7 mit aufgelöteter Kontaktelektrode 1 besteht. Dabei wird die strukturierte Seite der Kontaktelektrode 1 mit dem Leistungshalbleiterbauelement 7 kontaktiert. Dies geschieht zur genaueren Justierung in einer Lötform mit einer Aussparung in den Abmessungen des Leistungshalbleiterbauelements 7. Gate- oder Basisanschlüsse können wegen der kleineren elektrischen Ströme konventionell durch Ultraschall-Bonden oder Anlöten von Kopfdrähten hergestellt werden. Ein solcher Sandwich 11 kann in beliebigen Hybridschaltungen oder in Einzelgehäusen eingesetzt werden. Selbst ein nochmaliger Lötprozeß bei der gleichen Lotschmelztemperatur schadet nicht, da die Kontaktelektrode durch die Oberflächenspannung des Lotes festgehalten wird. Das Anlöten eines Kopfdrahtes kann entfallen, wenn beim Einbau in eine Hybridschaltung Kontaktbügel verwendet werden, die auf ihrer Unterseite mit Lot beschichtet sind. Die Kontaktelektrode 1 hat zweckmäßig die gleiche Größe wie das zu kontaktierende Bauelement 7. Dies erleichtert die Montage bei der Herstellung des Sandwich 11. Zur Vermeidung von Spannungsüberschlägen zwischen dem Rand des Leistungshalbleiterbauelements 7 und der Außenkante der Kontaktelektrode 1 ist das Silizium auch an den Trennstellen der Plättchen herausgeätzt, wie unter Herstellungsschritt 4 beschrieben und in Fig. 1 und 4 zu erkennen ist. Je nach Tiefätzung und Lotdicke entsteht so ein Spalt von einigen Hundert Mikrometern Breite, der sich beim anschließenden Kapseln des Sandwich 11 mit Isoliermasse füllt, so daß Überschläge wirksam verhindert werden.

Alternativ zum Laserschneiden gemäß Verfahrensschritt 6 können die Öffnungen 6 für Gate oder Basis auch durch Ultraschall-Schneiden hergestellt werden. Dazu wird die Siliziumscheibe zwischen Verfahrensschritt 2 und 3 auf einen Träger aufgeklebt und zwischen Schritt 4 und 5 wird das Ultraschall-Schneiden durchgeführt. Eine weitere Möglichkeit Öffnungen 6 herzustellen, bietet Ätzen. Dabei werden in eine z.B. 0,5 mm dicke Scheibe entsprechende Löcher geätzt. Diesen Ätzvorgang wird man zweckmäßig vor der Herstellung der Kontaktstruktur durchführen, d.h. zwischen Schritt 2 und 3. Dabei wird ebenfalls beidseitig maskiert. Auf die später zu strukturierende Seite werden bereits Justierhilfen mit aufgedruckt. Wegen der starken Ätzung fallen diese Justiersymbole relativ grob aus. Dies ist jedoch nicht störend, da die Positioniergenauigkeit der Gate-Öffnungen 6 relativ zu einer feingliedrigen Kontaktflächenstruktur unkritisch ist. Wenn die Anforderungen an die Genauigkeit der Kontaktstruktur größer sind, kann anstelle der Siebdrucktechnik die aufwendigere Photomaskentechnik eingesetzt werden.

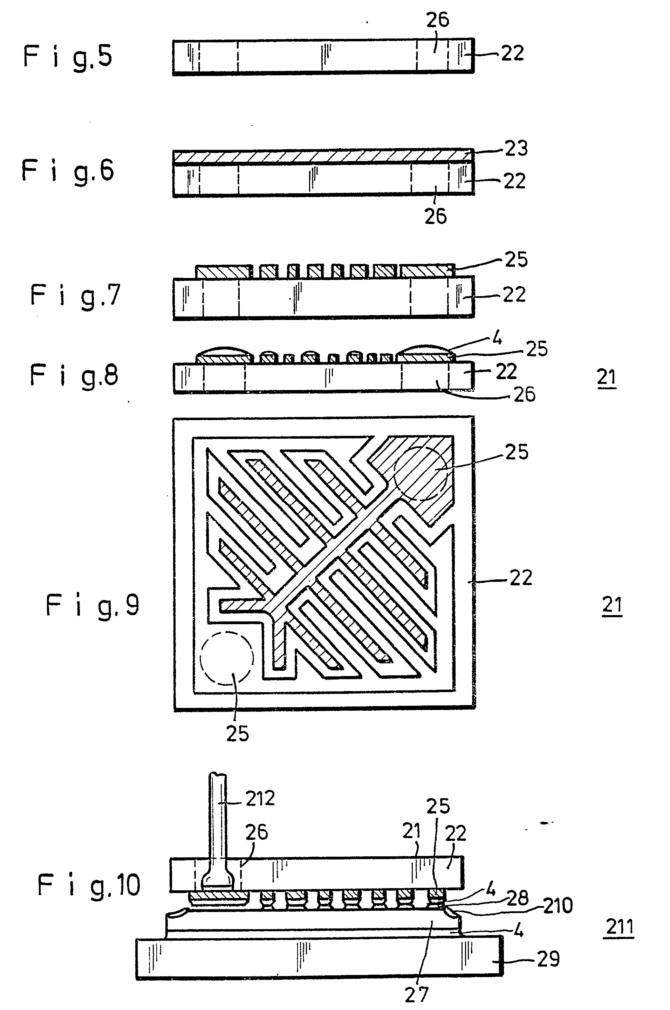

Die Fig. 5 bis 10 beziehen sich auf die Herstellung und Montage einer Kontaktelektrode 21 mit einem Plättchen 22 aus Keramik. Fig. 5 zeigt ein einzelnes solches Keramikplättchen 22. Bei der Herstellung von Kontaktelektroden 21 (siehe Fig. 8) geht man jedoch zweckmäßig von einer größeren Keramikplatte aus, aus welcher sich mehrere einzelne Kontaktelektroden 21 durch späteres Zerteilen herstellen lassen. In der Keramikplatte sind bereits mehrere Öffnungen 26 für eine spätere Durchführung von Kontaktelementen vorgesehen. Derartige Keramikplatten sind im Handel erhältlich. Die Keramikplatten können z.B. aus Aluminiumoxid oder aus Mullit bestehen. Mullit hat den Vorteil, daß es bezüglich des thermischen Ausdehnungskoeffizienten besser an Silizium, d.h. an die Ausdehnung eines Leistungshalbleiterbauelementes angepaßt ist.

Fig. 6 zeigt ein Keramikplättchen 22 nach dem ersten Herstellungsschritt, wobei eine Metallisierung 23 mit Hilfe eines bekannten Verfahrens zur direkten Verbindung von Metall mit Keramik auf das Keramikplättchen 22 aufgebracht wird. Zur Metallisierung verwendet man zweckmäßig eine Kupferfolie, die nach einem in der Patentanmeldung P 3 324 661.0 angegebenen Verfahren aufgebracht wird. Bei dem danach vorgeschlagenen Verfahren wird die mit der Keramik zu verbindende Seite der Kupferfolie aufgerauht, so daß parallellaufende Riefen entstehen. Dadurch wird eine besonders gute Haftung der Kupferfolie auf dem Keramikplättchen 22 erreicht.

Aufgrund der unterschiedlichen Ausdehnungskoeffizienten von Keramik und Kupfer ist prinzipiell bei Erwärmung eine Verformung einer solchen Metallkeramikverbindung möglich. Dieser Effekt ist jedoch in der Praxis vernachlässigbar, da die Keramik vorzugsweise eine Dicke von etwa 1 mm hat, während die Dicke der Kupferfolie vorzugsweise nur 0,2 mm beträgt, so daß die Ausdehnung im wesentlichen durch die Keramik bestimmt wird. Will man eine Durchbiegung ganz ausschließen, kann man die Keramik auch auf der zweiten Seite mit einer Metallisierung versehen.

Fig. 7 zeigt das Keramikplättchen 22 nach dem zweiten Herstellungsschritt, wobei durch Ätzung die gewünschte Kontaktstruktur, also Kontaktflächen 25, hergestellt werden. Dafür geeignete Ätzverfahren sind allgemein bekannt, z.B. aus der Leiterplattentechnik. Um die notwendige Genauigkeit und Feinheit der Struktur zu erzielen, kann man zur Ätzmaskierung je nach Anforderung eine Siebdruck- oder Fotolacktechnik anwenden. Zur Abdeckung der Öffnungen 26 in der Keramik werden die Keramikplatten auf ätzfeste Kunststofffolien aufgeklebt (nicht dargestellt). Nach dem Ätzen und Reinigen löst man die Keramikplatte wieder von der Folie ab. Zum Schutz der Kupferoberfläche vor Oxidation wird stromlos vernickelt und falls notwendig noch stromlos vergoldet (ebenfalls nicht dargestellt). Anschließend zerteilt man die Platte in die einzelnen Kontaktplättchen 22 durch Laserritzen und Brechen.

Fig. 8 zeigt die fertige Kontaktelektrode 21, wobei die Kontaktflächen 25 mit Weichlot 4 zuvor im Tauchbad vorbenetzt wurden.

Fig. 9 zeigt eine Draufsicht auf die Kontaktflächen 25 einer Kontaktelektrode 21. Dabei ist zu erkennen, daß die Kontaktflächen 25 zwei voneinander isolierte Flächen darstellen, die an die Struktur von Elektroden 28 eines Leistungshalbleiterbauelementes 27 (siehe Fig. 10) z.B. von Emitter und Basiselektroden eines Transistors angepaßt sind. Jede einzelne Fläche der Kontaktflächen 25 überdeckt eine Öffnung 26 im Keramikplättchen 22.

In Fig. 10 ist ein sogenannter Sandwich 211 dargestellt, wobei eine Kontaktelektrode 21 auf die Elektroden 28 eines Leistungshalbleiterbauelements 27 aufgelötet ist. Das dargestellte Leistungshalbleiterbauelement 27 hat einen Rand mit Passivierungsglas 210 und ist auf einen Chipträger 29 unter Verwendung von Weichlot 4 aufgelötet. Die Kontaktelektrode 21 und das Leistungshalbleiterbauelement 27 haben gleiche Abmessungen, so daß vorteilhaft Lötformen verwendet werden können. Die Verbindung der Kontaktelektrode 21 mit dem Leistungshalbleiterbauelement 27 kann im Durchlaufofenverfahren mittels Lötformen oder in einer automatischen Fertigungslinie durch Bestückungsgeräte erfolgen. Für die Herstellung von Außenanschlüssen kann man sogenannte Kopfdrähte 212 in die Öffnungen 26 der Kontaktelektrode 21 einsetzen und anlöten. Dabei wird die Löttemperatur etwas niedriger gewählt als bei vorherigem Lötprozeß. Bei Anwendungen in Leistungshybridschaltungen kann man die erforderlichen Verbindungen zur Substratmetallisierung anstelle von Kopfdrähten 212 über Kontaktbügel herstellen, die auf ihrer Unterseite mit Lot beschichtet sind und ebenfalls angelötet werden.

**Patentansprüche**

1. Kontaktelektrode, die vorgesehen ist zum Verlöten mit einem Leistungshalbleiterbauelement, das wenigstens eine Elektrode mit verteilter Struktur aufweist, wobei die Kontaktelektrode auf einer ersten Hauptfläche wenigstens eine strukturierte metallische Kontaktfläche hat, deren Form an diejenige der Leistungshalbleiterelektroden angepaßt ist, mit der die Kontaktelektrode verlötet werden soll und wobei die metallischen Kontaktflächen eine elektrische Verbindung zwischen zu einer Leistungshalbleiterelektrode gehörenden Elektrodenteilen herstellen, dadurch gekennzeichnet, daß die Kontaktelektrode (21) als Keramikplättchen (22) ausgeführt ist, auf dem die metallischen Kontaktflächen (25) aufgebracht sind, daß das Keramikplättchen (22) Öffnungen (26) zur Durchführung von Anschlußelementen (212) aufweist und daß jede einer Leistungshalbleiterelektrode (28) entsprechende Kontaktfläche (25) eine der Öffnungen (26) im Keramikplättchen (22) überdeckt.

2. Kontaktelektrode nach Anspruch 1, dadurch gekennzeichnet, daß die Metallisierung für die Kontaktflächen (25) durch ein Direct-Bonding-Verfahren hergestellt ist.

3. Kontaktelektrode nach Anspruch 1 oder 2, dadurch gekennzeichnet, daß die Metallisierung des Plättchens (22) aus Kupfer besteht.

4. Kontaktelektrode nach einem der Ansprüche 1 bis 3, dadurch gekennzeichnet, daß das Plättchen (22) aus Mullit besteht.

5. Kontaktelektrode nach einem der Ansprüche 1 bis 4, dadurch gekennzeichnet, daß das Plättchen (22) auf einer zweiten Hauptfläche, die der mit strukturierten Kontaktflächen (25) versehenen ersten Hauptfläche gegenüberliegt, ebenfalls eine Metallisierung aufweist.

6. Kontaktelektrode nach einem der Ansprüche 1 bis 5, dadurch gekennzeichnet, daß die Metallisierung eine dünne Beschichtung aus einem Metall besitzt, das gut durch Lot (4) benetzbar ist.

7. Kontaktelektrode nach Anspruch 6, dadurch gekennzeichnet, daß die beschichtete Metallisierung mit einem Lot (4) benetzt ist.

8. Kontaktelektrode, die vorgesehen ist zum Verlöten mit einem Leistungshalbleiterbauelement, das eine Elektrode verteilter Struktur aufweist, wobei die Kontaktelektrode auf einer ersten Hauptfläche eine strukturierte metallische Kontaktfläche hat, deren Form an diejenige der Leistungshalbleiterelektrode angepaßt ist, mit der die Kontaktelektrode verlötet werden soll und wobei die metallische Kontaktfläche eine elektrische Verbindung zwischen den zur Leistungshalbleiterelektrode gehörenden Elektrodenteilen herstellt, dadurch gekennzeichnet, daß die Kontaktelektrode (1) aus einem elektrisch leitenden Siliziumplättchen (2) besteht, das außer einer strukturierten metallisierten Kontaktfläche (5) auf der ersten Hauptfläche auch auf seiner nichtstrukturierten Rückseite eine Metallschicht aufweist, und die metallisierte Kontaktfläche (5) und auch die metallisierte Rückseite des Plättchens (2) mit Lot (4) benetzt sind.

9. Kontaktelektrode nach Anspruch 8, dadurch gekennzeichnet, daß die Kontaktelektrode (1) eine Fase oder Randvertiefung (12) aufweist.

**Claims**

1. Contact electrode, which is provided for soldering to a power semiconductor component which exhibits at least one electrode with a distributed structure, the contact electrode having on a first main face at least one structured metallic contact area the shape of which is matched to that of the power semiconductor electrodes to which the contact electrode is to be soldered, and the metallic contact areas establishing an electric connection between electrode parts belonging to a power semiconductor electrode, characterized in that the contact electrode (21) is constructed as a ceramic plate (22) to which the metallic contact areas (25) are applied, that the ceramic plate (22) exhibits openings (26) for passing through connection elements (212) and that each contact area (25) corresponding to a power semiconductor electrode (28) covers one of the openings (26) in the ceramic plate (22).

2. Contact electrode according to Claim 1, characterized in that the metallization for the contact areas (25) is produced by means of a direct-bonding method.

3. Contact electrode according to Claim 1 or 2, characterized in that the metallization of the plate (22) consists of copper.

4. Contact electrode according to one of Claims 1 to 3, characterized in that the plate (22) consists of mullite.

5. Contact electrode according to one of Claims 1 to 4, characterized in that the plate (22) also exhibits a metallization on a second main face which is opposite to the first main face provided with the structured contact areas (25).

6. Contact electrode according to one of Claims 1 to 5, characterized in that the metallization has a thin coating of a metal which can be wetted well by solder (4).

7. Contact electrode according to Claim 6, characterized in that the coated metallization is wetted with a solder (4).

8. Contact electrode which is provided for soldering to a power semiconductor component which exhibits an electrode of distributed structure, the contact electrode having on a first main face a structured metallized contact area the shape of which is matched to that of the power semiconductor electrode to which the contact electrode is to be soldered, and the metallic contact area establishing an electric connection between the electrode parts belonging to the power semiconductor electrode, characterized in that the contact electrode (1) consists of an electrically conductive silicon plate (2) which, in addition to a structured metallized contact area (5) on the first main face, also exhibits a metal layer on its non-structured rear, and the metallized contact area (5) and also the metallized rear of the plate (2) are wetted with solder (4).

9. Contact electrode according to Claim 8, characterized in that the contact electrode (1) exhibits a bezel or edge deepening (12).

**Revendications**

1. Electrode de contact, qui est prévue pour le brasage avec un composant semi-conducteur de puissance comportant au moins une électrode à structure divisée, l'électrode de contact comportant sur une première surface principale au moins une surface métallique structurée de contact, dont la forme est adaptée à celle-là des électrodes de semi-conducteur de puissance avec laquelle l'électrode de contact doit être brasée, et les surfaces métalliques de contact réalisant une connexion électrique entre les éléments d'électrode appartenant à une électrode de semi-conducteur de puissance, caractérisée en ce que l'électrode de contact (21) est réalisée sous forme d'une plaquette céramique (22) sur laquelle sont appliquées les surfaces métalliques (25) de contact, en ce que la plaquette céramique (22) présente des ouvertures (26) pour le passage d'éléments de connexion (212) et en ce que chaque surface de contact (25) correspondant à une électrode de semi-conducteur de puissance (28) recouvre une des ouvertures (26) dans la plaquette céramique (22).

2. Electrode de contact selon la revendication 1, caractérisée par le fait que la métallisation pour les surfaces de contact (25) est réalisée par un procédé de liaison directe (direct bonding).

3. Electrode de contact selon la revendication 1 ou 2, caractérisée par le fait que la couche de métallisation de la plaquette (22) est à base de cuivre.

4. Electrode de contact selon l'une des revendications 1 à 3, caractérisée par le fait que la plaquette (22) est constituée de mullite.

5. Electrode de contact selon l'une des revendications 1 à 4, caractérisée par le fait que la plaquette (22) présente également une métallisation sur une seconde surface principale qui est opposée à la première surface principale munie de surfaces structurées (25) de contact.

6. Electrode de contact selon l'une des revendications 1 à 5, caractérisée par le fait que la couche de métallisation comporte un mince revêtement à base d'un métal qui est aisément mouillable par la brasure (4).

7. Electrode de contact selon la revendication 6, caractérisée par le fait que la partie métallisée revêtue est mouillée par une brasure (4).

8. Electrode de contact, qui est prévue pour le brasage avec un composant semi-conducteur de puissance comportant une électrode à structure divisée, l'électrode de contact comportant sur une première surface principale une surface métallique structurée de contact, dont la forme est adaptée à celle-là des électrodes de semi-conducteur de puissance avec laquelle l'électrode de contact doit être brasée, et la surface métallique de contact réalisant une connexion électrique entre les éléments d'électrode appartenant à l'électrode de semi-conducteur de puissance, caractérisée en ce que l'électrode de contact (1) est constituée d'une plaquette de silicium (2) conductrice de l'électricité, qui, outre une surface métallisée structurée (5) de contact, présente sur la première surface principale, également sur l'envers non structuré de celle-ci, une couche métallique, et la surface métallisée (5) de contact ainsi que l'envers métallisé de la plaquette (2) sont mouillés avec de la brasure (4).

9. Electrode de contact selon la revendication 8, caractérisée par le fait que l'électrode de contact (1) présente un chanfrein ou évidement latéral (12).

Fig.1

5  5  4
3
12
2
3
4

1

Fig.2

6
5

1

Fig.3

10
8
9

7

Fig.4

1
12
10
7

11

Fig.5

Fig.6

Fig.7

Fig.8

Fig.9

Fig.10